(19) Europäisches Patentamt / European Patent Office / Office européen des brevets

(11) **EP 4 254 068 A1**

(12) **EUROPEAN PATENT APPLICATION**

(43) Date of publication:
   **04.10.2023 Bulletin 2023/40**

(21) Application number: **22164691.2**

(22) Date of filing: **28.03.2022**

(51) International Patent Classification (IPC):
   **G03F 7/20** (2006.01)    **G03F 9/00** (2006.01)

(52) Cooperative Patent Classification (CPC):
   **G03F 7/70625; G03F 7/70525; G03F 7/70616;
   G03F 7/70633; G03F 9/7003**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**
   Designated Validation States:
   **KH MA MD TN**

(71) Applicant: **ASML Netherlands B.V.
   5500 AH Veldhoven (NL)**

(72) Inventor: **COTTAAR, Jeroen
   5500 AH Veldhoven (NL)**

(74) Representative: **ASML Netherlands B.V.
   Corporate Intellectual Property
   P.O. Box 324
   5500 AH Veldhoven (NL)**

(54) **METHOD FOR DETERMINING A SPATIAL DISTRIBUTION OF A PARAMETER OF INTEREST OVER AT LEAST ONE SUBSTRATE OR PORTION THEREOF**

(57)   Disclosed is a method for determining a spatial distribution of a parameter of interest over at least one substrate or portion thereof, the substrate having been subject to a semiconductor manufacturing process, the method comprising obtaining a statistical description (SD) describing an expected characteristic of the parameter of interest and metrology data (MD) related to the parameter of interest. Using the statistical description as a prior and the metrology data as an observation, the spatial distribution of the parameter of interest (CFP) over the at least one substrate or portion thereof is inferred via Bayesian inference.

Fig. 3

EP 4 254 068 A1

**Description**

BACKGROUND

Field of the Invention

The present invention relates to methods and apparatus for applying patterns to a substrate in a lithographic process.

Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In performing semiconductor manufacturing processes, such as lithographic processes, such as application of a pattern on a substrate or measurement of such a pattern, process control methods are used to monitor and control the process. Such process control techniques are typically performed to obtain corrections for control of the semiconductor manufacturing process. It would be desirable to improve such process control methods. In particular, process corrections are typically based on modelled metrology data, where the modelling may be based on a fitting of base functions to the measured data. Base function based modelling is not optimal as it is not based on domain knowledge/actual observed characteristics of fingerprints. This risks the fitting of an incorrect or poor model for the metrology data (e.g. sub-optimal base functions).

SUMMARY OF THE INVENTION

In a first aspect of the invention, there is provided a method for determining a spatial distribution of a parameter of interest over at least one substrate or portion thereof, the at least one substrate having been subject to a semiconductor manufacturing process, the method comprising: obtaining a statistical description describing an expected characteristic of said parameter of interest; obtaining metrology data related to said parameter of interest; and inferring via Bayesian inference said spatial distribution of the parameter of interest over the at least one substrate or portion thereof, using said statistical description as a prior and said metrology data as an observation.

The invention yet further provides a processing arrangement, metrology device and lithographic apparatus comprising the computer program of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for semiconductor devices;
Figure 2 comprises a schematic diagram of a scatterometer for use in measuring targets according to embodiments of the invention;
Figure 3 is a flow diagram describing a method according to an embodiment.

DETAILED DESCRIPTION

Before describing embodiments of the invention in detail, it is instructive to present an example environment in which embodiments of the present invention may be implemented.

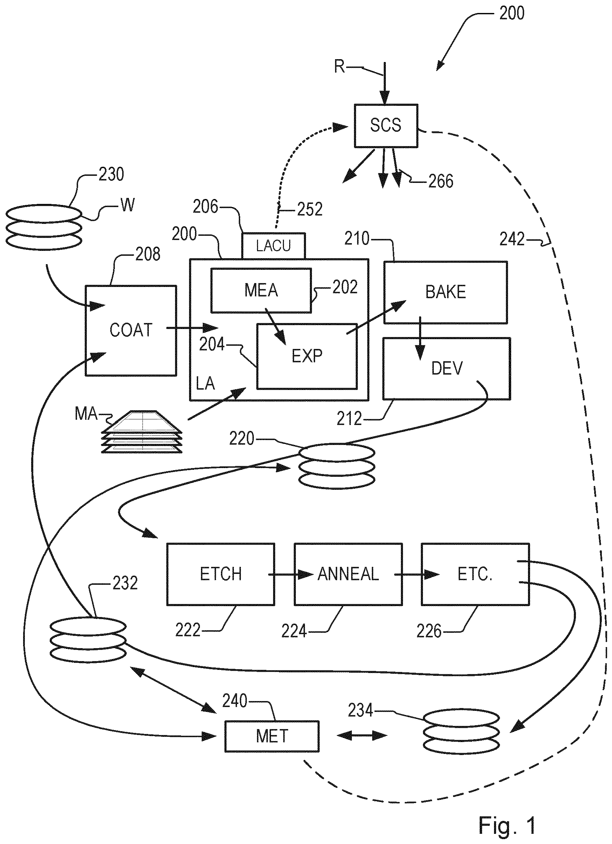

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

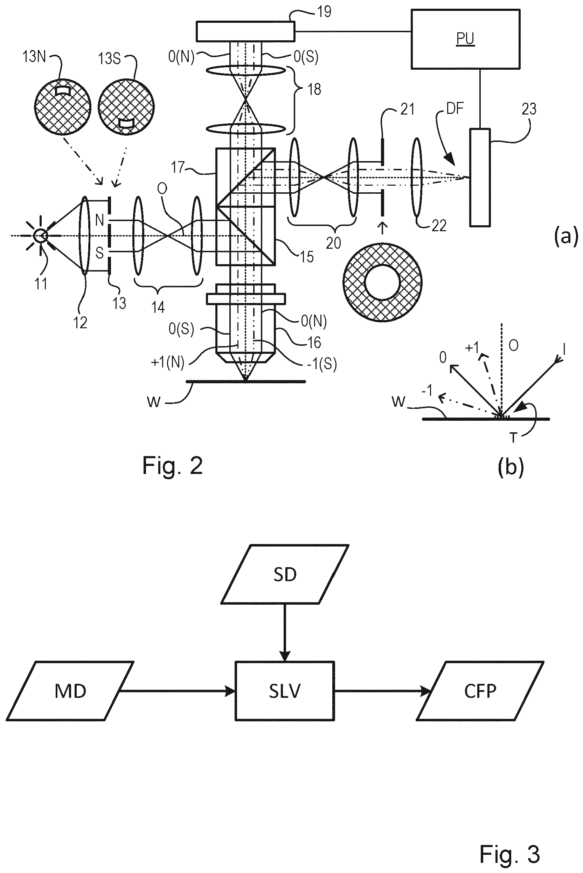

A metrology apparatus suitable for use in embodiments of the invention is shown in Figure 2(a). A target T and diffracted rays of measurement radiation used to illuminate the target are illustrated in more detail in Figure 2(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 2(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 2(a) and 2(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 2(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for many measurement purposes such as reconstruction used in methods described herein. The pupil plane image can also be used for focusing the metrology apparatus and/or normalizing intensity measurements of the first order beam.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 2 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 2) can be used in measurements, instead of or in addition to the first order beams.

The target T may comprise a number of gratings, which may have differently biased overlay offsets in order to facilitate measurement of overlay between the layers in which the different parts of the composite gratings are formed. The gratings may also differ in their orientation, so as to diffract incoming radiation in X and Y directions. In one example, a target may comprise two X-direction gratings with biased overlay offsets +d and -d, and Y-direction gratings with biased overlay offsets +d and -d. Separate images of these gratings can be identified in the image captured by sensor 23. Once the separate images of the gratings have been identified, the intensities of those individual images can be measured, e.g., by averaging or summing selected pixel intensity values within the identified areas. Intensities and/or other properties of the images can be compared with one another. These results can be combined to measure different parameters of the lithographic process.

Control methods for lithographic processes typically rely on measuring a parameter of interest indicative of quality, and therefore functionality/yield of the circuit being manufactured, at multiple points on a wafer or a portion thereof (e.g., an exposure field). These measurements may be modeled to interpolate values for the parameter of interest at locations between the measurement points, where the value is actually known. The modeled measurements may be referred to as a fingerprint, which is a spatial distribution of the parameter of interest (or another parameter) over the wafer or wafer portion thereof. Alternatively, they may comprise temporal or context distributions. The parameter of interest may be any parameter indicative of or relevant to device functionality/yield. Common examples are overlay, an alignment or positioning parameter (grid position/modeling of a wafer grid), a position parameter per layer such as edge placement error (EPE), critical dimension (CD), a leveling parameter (e.g., height of wafer surface), an etch parameter, any other processing parameter and any metrology parameter which results in a metrology fingerprint. Such a fingerprint can be used, for example, for diagnostics and control of the lithographic process (after applying optimization, e.g., translating the fingerprint into scanner actuation parameters).

A main issue with modeling parameter of interest fingerprints is finding the best method to estimate the parameter of interest everywhere on the wafer (or a portion thereof), given a finite set of parameter of interest measurement points. It is known to model the measured parameter of interest data by fitting a predefined set of basis functions (chosen during model setup) to the measured data. The basis functions can then be evaluated anywhere to obtain a full-wafer prediction. Computational metrology is another method having the same basic approach, but which uses additional data of a different type (data from a different domain) to improve the parameter of interest prediction (e.g., where the parameter of interest is overlay, the additional data may be one or more of alignment, leveling and/or servo error data as reported by the scanner).

A limitation currently observed in such estimation methods is poor performance on sampling layouts larger than about 500 points per wafer. When measuring fewer points than this, basis function based estimation models perform satisfactorily. However, when the sampling is greater than 500 points, their performance is overtaken by models for which no global estimation takes place and a per field (e.g., correction per exposure or CPE) modelling is performed. Most physical causes of wafer fingerprints do not relate to exposure fields, and as such their fingerprints will not show any per-field behavior. Therefore, CPE models should not be expected to give the actual best performance, meaning there should be better estimation models out there for this >500 point range.

A fundamental limitation of the current approach is that it is not directly based on physical knowledge. By way of a specific example, it has been observed that the present estimation models do not perform well on ring-like fingerprints that often appear in 3D-NAND structures. This was addressed successfully by implementing new basis functions better suited to capture these fingerprints. However that such new basis functions have to be designed adds an addition layer of non-physical content over the basic physical knowledge that ring fingerprints occur.

To address this issue, a new modeling approach for fingerprint determination is proposed which relies on actual physical knowledge of the parameter of interest fingerprints or spatial distributions. More specifically, the proposed approach is based on Bayesian approximation or Bayesian inference.

Bayesian inference is a method of statistical inference in which Bayes' theorem is used to update the probability for a hypothesis as more evidence or information becomes available. Bayesian inference derives the posterior probability as a consequence of two antecedents: a prior probability and a "likelihood function" derived from a statistical model or description for the observed (measured) data. The result is a continuously updated estimate or fingerprint, which is updated each time new data is available.

The proposed method may use a formal, statistical description (the prior) of how the parameter of interest (including noise) is expected to behave, and metrology data; e.g., at least parameter of interest metrology data comprising a set of measurements of the parameter of interest. The metrology data may optionally also include other metrology data of a different type to the parameter of interest (e.g., *inter alia* alignment data, leveling data, servo error data, after-develop inspection (ADI) overlay versus after-etch inspection (AEI) overlay data, EPE data). As such, the prior does may include elements or parameters other than the parameter of interest.

Figure 3 is a conceptual flow diagram of such a method. The statistical description SD is used as the Bayesian prior, which is updated by the solver SLV based on new metrology data MD (observations). Based on these two inputs SD, MD, the solver SLV determines which set of root causes are most likely to explain the observations (i.e., metrology data MD). This is a formal mathematical problem and may be posed, provided certain criteria are met (i.e., that all distributions in the prior are Gaussian and the relationship between the parameters in the prior and the observations is linear), such as to require only a single matrix inversion to solve. The output may comprise a continuously updated parameter of interest fingerprint CFP.

The statistical description or prior may comprise any known expected behavior of the parameter of interest, e.g., based on previous observation, known physical and/or expert knowledge. For example, the prior may comprise one or more expected parameter of interest distribution (fingerprint) shapes. By way of an overlay example, it is known that the overlay measurements are a sum of at least the following components:

- An interfield shape, expected to be smooth.
- An intrafield shape, expected to be smooth.
- A slit fingerprint, expected to be smooth.
- A scan-up scan-down shape, expected to be smooth.
- A step-left step-right shape, expected to be smooth.
- An edge roll-off shape that depends only on radius, expected to be smooth.
- A shape per exposure field, expected to be smooth.
- Measurement noise, expected to be small.

As such, the statistical description for overlay may comprise any one or more of, two or more of, three or more of, four or more of, five or more of, six or more of, or all of the components listed immediately above. The prior may therefore be constructed from any number of such shapes based on previous observed overlay shapes. As the prior may comprise a statistical distribution (e.g., a spatial distribution with error bars) it can be sampled from directly. At least some of these components may be applicable to other parameters of interest such as edge placement error.

In each of these components, other than noise, the distribution component or fingerprint component shape is expected to be smooth. In this context, smoothness may be quantified by the bending energy of the model, specifically for a given shape $m(x,y)$:

$$\text{bending energy}(m) = \iint\limits_{\text{wafer}} \mathrm{d}x\mathrm{d}y \left( \left(\frac{\partial^2 m}{\partial x^2}\right)^2 + \left(\frac{\partial^2 m}{\partial y^2}\right)^2 + 2\left(\frac{\partial^2 m}{\partial x \partial y}\right)^2 \right)$$

Conceptually, in a physical setting where m(x,y) describes the height of a thin plate of metal, this functional is really proportional to the bending energy related to the bending of the plate.

Alternative definitions for smoothness, which may be used in place of bending energy, include the curl or divergence of the distribution component or fingerprint component (e.g., a vector field).

When a shape is expected to behave in a certain way, e.g., "expected to be smooth", this is a statistical statement. This relates to the solver finding the most likely solutions as described above. As such, the solver finds solutions which minimize the bending energy for each of components included in the prior. In this manner, the tuning parameters in the model (e.g., how smooth the shapes are expected to be, and how large measurement noise is expected to be) have physical meaning, unlike choices in the classic models (e.g., choosing the order of the polynomial to fit). Furthermore, the breakdown into physical effects is very useful for diagnostics.

It should be appreciated that the solver may fit all of the aforementioned components simultaneously. As such, using the overlay example given, the solver may fit the fingerprint model by simultaneously minimizing the bending energy for each of the shape components included in the prior, and (where included) by minimizing the measurement noise.

In addition, the fit may be performed on all measured wafers simultaneously, instead of per-wafer as is more typical. This results in a much improved performance when wafers do not have a common sampling scheme; all wafers may be used to find common shapes. The same results cannot be achieved by averaging first, since then global content per-wafer leaks into this average wafer. As such, varying the sampling per field or per wafer can be used in an efficient manner. For example, it has been shown that an accurate SUSD fingerprint may be determined from a sampling of very few points in both scan-up and scan-down fields.

Note that the concept of Bayesian approximation is not limited to the example statistical descriptions above. In particular, it is possible that the statistical description may be extended or improved with more specific knowledge; for example the description may be improved by including one or more of: wafer heating data, map of wafer height Z to X-Y position, servo error data, scanner grid deformations, pattern shift data, heating data (e.g., one or more of lens heating data, reticle heating data, wafer heating data), drift data (e.g., intra-wafer drift data, intra-lot drift data, longer-term drift data), mark print error, ADI-ACI (after clean inspection) matching data, radial inner wafer models, modes of variation (e.g., as part of principal component analysis (PCA)), advanced process correction data, intrafield etch impact data. Also, the prior may be improved as knowledge changes; e.g., other global shapes and other quantifications of smoothness than those described may prove to be better in future.

In an embodiment, the solver may be used within the scanner on a per wafer basis, e.g., immediately or soon after measuring alignment data.

It can be appreciated that the proposed methodology can be extended with new physical effects in a straightforward manner as any new effect can be added to the statistical description, without it being necessary to provide/determine new modeling flows.

Further embodiments of the invention are disclosed in the list of numbered clauses below:

1. A method for determining a spatial distribution of a parameter of interest over at least one substrate or portion thereof, the at least one substrate having been subject to a semiconductor manufacturing process, the method comprising: obtaining a statistical description describing an expected characteristic of said parameter of interest; obtaining metrology data related to said parameter of interest; and inferring via Bayesian inference said spatial distribution of the parameter of interest over the at least one substrate or portion thereof, using said statistical description as a prior and said metrology data as an observation.

2. A method according to clause 1, wherein statistical description describes a distribution associated with the semiconductor manufacturing process.

3. A method according to clause 2, wherein said distribution comprises a spatial, temporal or context distribution.

4. A method according to any preceding clause, wherein the statistical description comprises at least one expected component of the spatial distribution of said parameter of interest.

5. A method according to clause 4, wherein at least one expected component comprises a plurality of expected components of the spatial distribution of said parameter of interest; and
said inferring step comprises simultaneously fitting each of said expected components to said metrology data.

6. A method according to clause 4 or 5, wherein said metrology data comprises a plurality of metrology datasets, each metrology dataset relating to a respective substrate of a plurality of substrates, and said inferring step comprises fitting each said at least one expected component to each said metrology dataset simultaneously.

7. A method according to clause 6, wherein the measurement sampling for each said metrology dataset is varied over said metrology datasets.

8. A method according to any of clauses 4 to 7, wherein the at least one expected component comprises one or more expected shape components of the spatial distribution of said parameter of interest.

9. A method according to clause 8, wherein the statistical description comprises a plurality of said expected shape components of the spatial distribution of said parameter of interest.

10. A method according to clause 8 or 9, wherein some or each of said one or more expected shape components are each expected to be smooth according to the statistical description.

11. A method according to clause 10, wherein each of said one or more expected shape components is expected to have a low bending energy, divergence or curl.

12. A method according to clause 11, wherein said inferring step comprises fitting said one or more components to said metrology data so as to minimize the bending energy, divergence or curl for each shape component expected to be smooth.

13. A method according to any of clauses 8 to 12, wherein the semiconductor manufacturing process is a lithographic process and each of said one or more expected shape components comprises one or more of: an interfield shape, an intrafield shape, a slit fingerprint, a scan-up scan-down shape, a step-left step-right shape, an edge roll-off shape that depends only on radius and a shape per exposure field.

14. A method according to any of clauses 8 to 12, wherein each of said one or more expected shape components comprises two or more of: an interfield shape, an intrafield shape, a slit fingerprint, a scan-up scan-down shape, a step-left step-right shape, an edge roll-off shape that depends only on radius and a shape per exposure field.

15. A method according to any of clauses 8 to 12, wherein each of said one or more expected shape components comprises three or more: an interfield shape, an intrafield shape, a slit fingerprint, a scan-up scan-down shape, a step-left step-right shape, an edge roll-off shape that depends only on radius and a shape per exposure field.

16. A method according to any of clauses 8 to 12, wherein each of said one or more expected shape components comprises each of: an interfield shape, an intrafield shape, a slit fingerprint, a scan-up scan-down shape, a step-left step-right shape, an edge roll-off shape that depends only on radius and a shape per exposure field.

17. A method according to any of clauses 4 to 16, wherein each said at least one expected component comprises a statistical spatial distribution over the substrate or portion thereof.

18. A method according to any of clauses 4 to 17, wherein the at least one expected component comprises a noise component describing expected measurement noise.

19. A method according to clause 18, wherein the description of expected measurement noise comprises expecting the measurement noise to be small.

20. A method according to clause 18 or 19, wherein said inferring step comprises fitting said one or more components to said metrology data such that the measurement noise is minimized.

21. A method according to any of clauses 4 to 20, wherein the at least one expected component comprises one or more components relating to a shape or other characteristic one or more of: wafer heating data, map of wafer height Z to X-Y position, servo error data, scanner grid deformations, pattern shift data, heating data, drift data, mark print error, ADI-ACI matching data, radial inner wafer models, modes of variation as part of principal component analysis, advanced process correction data and intrafield etch impact data.

22. A method according to any preceding clause, wherein said metrology data comprises a set of measurements of the parameter of interest.

23. A method according to any preceding clause, wherein said metrology data comprises a set of measurements of a parameter other than said parameter of interest and/or relating to a domain other than that of said parameter of interest.

24. A method according to any preceding clause, wherein the method is repeated each time new metrology data becomes available.

25. A method according to any preceding clause, comprising performing said method for each substrate prior to performing a semiconductor manufacturing exposure process on each substrate.

26. A method according to clause 25, comprising performing said method between performing an alignment process and a lithographic exposure process on each substrate.

27. A method according to any preceding clause, further comprising controlling a lithographic apparatus configured to provide product structures to a substrate in a lithographic process using said spatial distribution of the parameter of interest.

28. A computer program comprising program instructions operable to perform the method of any of clauses 1 to 27, when run on a suitable apparatus.

29. A non-transient computer program carrier comprising the computer program of clause 28.

30. A processing arrangement comprising:

a computer program carrier comprising the computer program of clause 29; and
a processor operable to run said computer program.

31. A metrology device comprising the processing arrangement of clause 30.

32. A lithographic apparatus comprising the processing arrangement of clause 30.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method for determining a spatial distribution of a parameter of interest over at least one substrate or portion thereof, the at least one substrate having been subject to a semiconductor manufacturing process, the method comprising:

    obtaining a statistical description describing an expected characteristic of said parameter of interest;
    obtaining metrology data related to said parameter of interest; and
    inferring via Bayesian inference said spatial distribution of the parameter of interest over the at least one substrate or portion thereof, using said statistical description as a prior and said metrology data as an observation.

2. A method as claimed in claim 1, wherein statistical description describes a spatial distribution of a parameter associated with the semiconductor manufacturing process.

3. A method as claimed in any preceding claim, wherein the statistical description comprises at least one expected component of the spatial distribution of said parameter of interest

4. A method as claimed in claim 3, wherein at least one expected component comprises a plurality of expected components of the spatial distribution of said parameter of interest; and
said inferring step comprises simultaneously fitting each of said expected components to said metrology data.

5. A method as claimed in claim 3 or 4, wherein said metrology data comprises a plurality of metrology datasets, each metrology dataset relating to a respective substrate of a plurality of substrates, and said inferring step comprises fitting each said at least one expected component to each said metrology dataset simultaneously.

6. A method as claimed in any of claims 3 to 5, wherein the at least one expected component comprises one or more expected shape components of the spatial distribution of said parameter of interest.

7. A method as claimed in claim 6, wherein the statistical description comprises a plurality of said expected shape components of the spatial distribution of said parameter of interest.

8. A method as claimed in claim 6 or 7, wherein some or each of said one or more expected shape components are each expected to be smooth according to the statistical description.

9. A method as claimed in claim 8, wherein each of said one or more expected shape components is expected to have a low bending energy, divergence or curl.

10. A method as claimed in claim 9, wherein said inferring step comprises fitting said one or more components to said metrology data so as to minimize the bending energy, divergence or curl for each shape component expected to be smooth.

11. A method as claimed in any of claims 3 to 10, wherein the semiconductor manufacturing process is a lithographic process and each of said one or more expected shape components comprises one or more of: an interfield shape, an intrafield shape, a slit fingerprint, a scan-up scan-down shape, a step-left step-right shape, an edge roll-off shape that depends only on radius and a shape per exposure field.

12. A method as claimed in any of claims 3 to 11, wherein the at least one expected component comprises one or more components relating to a shape or other characteristic one or more of: wafer heating data, map of wafer height Z to X-Y position, servo error data, scanner grid deformations, pattern shift data, heating data, drift data, mark print error, ADI-ACI matching data, radial inner wafer models, modes of variation as part of principal component analysis, advanced process correction data and intrafield etch impact data.

13. A method as claimed in any preceding claim, wherein said metrology data comprises a set of measurements of a parameter other than said parameter of interest and/or relating to a domain other than that of said parameter of interest.

14. A computer program comprising program instructions operable to perform the method of any of claims 1 to 13, when run on a suitable apparatus.

15. A non-transient computer program carrier comprising the computer program of claim 14.

Fig. 1

Fig. 2

(a)

(b)

Fig. 3

Europäisches
Patentamt

European
Patent Office

Office européen
des brevets

# EUROPEAN SEARCH REPORT

Application Number

EP 22 16 4691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/186910 A1 (FUKUDA HIROSHI [JP]) 20 June 2019 (2019-06-20) * paragraphs [0002] – [0004] * * paragraphs [0045] – [0052] * * paragraph [0061] * * paragraphs [0072] – [0088]; figures 4,6 * | 1-4,6-15 | INV. G03F7/20 G03F9/00 |
| X | US 2021/255547 A1 (VAN DONGEN JEROEN [NL] ET AL) 19 August 2021 (2021-08-19) * paragraphs [0007] – [0008] * * paragraphs [0136] – [0138] * * paragraphs [0156] – [0183]; figures 3,4 * * paragraph [0252] * * paragraphs [0284] – [0291] * | 1-5,11, 14,15 | |

TECHNICAL FIELDS SEARCHED (IPC)

G03F

The present search report has been drawn up for all claims

| Place of search | Date of completion of the search | Examiner |
|---|---|---|
| Munich | 2 September 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................

& : member of the same patent family, corresponding document

EPO FORM 1503 03.82 (P04C01)

**EP 4 254 068 A1**

## ANNEX TO THE EUROPEAN SEARCH REPORT
## ON EUROPEAN PATENT APPLICATION NO.

EP 22 16 4691

02-09-2022

| Patent document cited in search report | | Publication date | Patent family member(s) | | Publication date |
|---|---|---|---|---|---|
| US 2019186910 | A1 | 20-06-2019 | KR | 20190029670 A | 20-03-2019 |
| | | | KR | 20200128193 A | 11-11-2020 |
| | | | TW | 201812251 A | 01-04-2018 |
| | | | US | 2019186910 A1 | 20-06-2019 |
| | | | WO | 2018042581 A1 | 08-03-2018 |
| US 2021255547 | A1 | 19-08-2021 | CN | 112272796 A | 26-01-2021 |
| | | | KR | 20210010917 A | 28-01-2021 |
| | | | TW | 202001409 A | 01-01-2020 |
| | | | US | 2021255547 A1 | 19-08-2021 |
| | | | WO | 2019233743 A1 | 12-12-2019 |

EPO FORM P0459

**EP 4 254 068 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1